# FASCICULE DE BREVET EUROPEEN

(11) **EP 1 414 148 B1**
(45) Date de publication et mention de la délivrance du brevet: **13.08.2008**
(21) Numéro de dépôt: 03362020.4
(22) Date de dépôt: 23.10.2003
(51) Int. Cl.: H03F 1/02, H03F 3/193, H03F 1/32

(54) **Amplificateur de puissance pour systemes de transmission radiofrequences**
Leistungsverstärker für Hochfrequenz-Transmissionssysteme
Power amplifier for radio frequency transmission systems

(30) Priorité: 25.10.2002 FR 0213381
(43) Date de publication de la demande: 28.04.2004
(73) Titulaire: LPA Concepts, 33650 Martillac (FR)
(72) Inventeur: Powell, Jack Francis, 33140 Cadaujac (FR)
(74) Mandataire: Thébault, Jean-Louis

(56) Documents cités:
- EP-A- 0 524 772
- EP-A- 0 673 112
- WO-A-02/17478
- US-A- 6 008 698
- US-A1- 2002 014 920
- PATENT ABSTRACTS OF JAPAN vol. 006, no. 064 (E-103), 23 avril 1982 (1982-04-23) & JP 57 004607 A (FUJITSU LTD), 11 janvier 1982 (1982-01-11)
- "The PM2105 Power Amplifier. Application note 2594 " 30 juin 2000 (2000-06-30) , PACIFIC MONOLITHICS , WWW.RFPOWERNET.COM XP002241148 * le document en entier *

## Description

La présente invention se rapporte aux amplificateurs de puissance utilisés dans les émetteurs de radiotéléphones dits de troisième génération ou de radiodiffusion numérique et plus généralement aux amplificateurs de puissance supportant des signaux présentant des écarts importants entre la puissance crête et la puissance moyenne pouvant atteindre un rapport de 10/1.

Ce type de modulation génère des écarts importants entre la puissance de crête des signaux et la puissance moyenne qui peuvent atteindre un rapport de 10/1.

Dans de tels systèmes de transmission, si l'on veut que le signal de sortie soit une réplique exacte du signal d'entrée, autrement dit si l'on veut réaliser une amplification linéaire, il faut que l'amplificateur puisse amplifier aussi bien les crêtes que les signaux les plus faibles. C'est ainsi que, par exemple, pour émettre une puissance moyenne de 20 watts il faut un amplificateur de 200 watts. Malheureusement cet amplificateur de 200 watts n'émettra que 20 watts en moyenne, avec un rendement très inférieur à son rendement optimal, puisque, comme l'on sait, le rendement électrique, c'est-à-dire le rapport puissance de sortie / puissance consommée, n'est maximum que lorsque l'amplificateur fonctionne au maximum de sa puissance, à savoir lorsque son gain commence à décroître.

C'est ainsi qu'avec un tel amplificateur, pour un signal de puissance signal de crête / puissance signal moyen (P crête / P moyen) de 10 dB on peut obtenir un rendement de seulement 15 %, qui est néanmoins considéré comme excellent.

Jusqu'à maintenant la plupart des efforts pour améliorer le rendement se sont concentrés sur la réduction du rapport P crête / P moyen en modifiant les modulations ou en utilisant des techniques digitales afin de diminuer les crêtes.

Cependant on sait depuis longtemps que si l'on arrive à moduler la tension d'alimentation de l'amplificateur radiofréquence (RF) au rythme de l'enveloppe du signal, on peut gagner en rendement. Une telle modulation, appelée "enveloppe tracking" est décrite dans l'article de F.H. RAAB (F.H. RAAB, High efficiency amplification techniques, IEEE Circuits & Systems Journal, N° 7, Décembre 1975, pages 3 - 11) où un amplificateur en classe S est utilisé pour fournir une tension d'alimentation variable.

D'autres auteurs ont proposé d'utiliser un convertisseur DC - DC dont on peut faire varier la tension de sortie pour alimenter l'amplificateur. Mais dans ce cas comme dans beaucoup d'autres on est limité à des vitesses de variation de la tension de l'ordre du MHz.

Par ailleurs, la demande de brevet US publiée N° 2002/0094795 enseigne que la meilleure façon de passer d'une tension à une autre rapidement est en fait de commuter plusieurs alimentations distinctes.

Toutefois, ces commutations générant des sauts d'amplitude et de phase, il est proposé de compenser ces sauts par une pré-correction.

Cette technique néanmoins soulève quelques problèmes.

Il n'est pas aisé en effet de commuter deux alimentations de tensions distinctes car tous les amplificateurs radiofréquences de puissance nécessitent des condensateurs de forte valeur sur les drains des transistors afin d'assurer leur linéarité. Il est très courant par exemple de voir des capacités de 100 µF. Charger un condensateur de 100 µF de 10 V en 1 µs nécessite un courant de 1 000 A. Or les signaux modernes ont souvent des enveloppes qui varient beaucoup plus vite que cela (UMTS = 5 MHz = 200ns).

Même si l'on arrive à diminuer les résistances de façon à faire passer ces courants, un second problème est que ces commutations sont de moins en moins propres lorsque celles-ci sont de plus en plus rapides. Les inductances parasites même minimes provoquent en effet des rebondissements des tensions d'alimentation. Ces rebondissements provoquent à leur tour une détérioration du signal de sortie (bruit, intermodulation, ...).

La précorrection est une technique efficace pour des régimes établis mais plus difficile à appliquer sur des régimes transitoires de vitesse élevée.

La demande de brevet US publiée N° 2002/0094795 propose d'utiliser des modulateurs d'amplitude et de phase afin d'appliquer une telle pré-correction. Il va dès lors se poser le problème de la vitesse et de la linéarité des modulateurs, à supposer qu'il n'y ait pas de phénomène de mémoire.

La présente invention vise à moduler la tension d'alimentation de l'amplificateur RF par commutation de tension mais de manière que cette commutation soit plus propre, c'est-à-dire avec le moins possible d'inductances parasites, en sorte de provoquer le moins de perturbations possible du signal de sortie.

A cet effet, l'invention a pour objet

Suivant une application de l'invention à la commutation de deux tensions d'alimentation distinctes, l'étage de commutation est agencé en sorte de commuter sur le drain la tension d'alimentation la plus élevée en même temps que ledit troisième étage de découplage et la tension d'alimentation la moins élevée en même temps qu'un quatrième étage de découplage constituant un réservoir de charge à long terme assurant la stabilité de la tension drain.

Suivant une variante de réalisation de l'invention appliquée à la réalisation d'un amplificateur requérant une linéarité importante du signal de sortie, l'étage de sortie dudit amplificateur comporte une boucle de réaction amont dénommée feedforward en sorte de corriger les perturbations transitoires rapides provoquées par les commutations de tension d'alimentation dudit étage de sortie.

L'utilisation d'une telle boucle, connue en elle-même, en combinaison avec l'étage de commutation de tension, est particulièrement judicieuse et intéressante car elle permet, conformément à l'invention, de réduire très sensiblement le bruit et l'intermodulation, qui est la caractéristique bien connue du feedforward, mais en éliminant l'inconvénient également bien connu d'un tel système à savoir sa vulnérabilité à la compression de gain de l'amplificateur lors des crêtes de puissance, cet inconvénient étant, dans le cadre de la présente invention, pratiquement supprimé, la compression de gain étant compensée par la commutation de tension sur ledit amplificateur. La puissance crête sera ainsi améliorée en même temps que le rendement.

Selon un mode de réalisation particulier de l'invention, l'étage de commutation de tension est commandé par un circuit de commande relié à l'entrée de l'amplificateur via un circuit de détection d'enveloppe du signal.

Plus particulièrement, le commutateur peut commuter plus de deux tensions, à chaque tension étant associé un étage de découplage spécifique, en sorte de moduler la tension d'alimentation de l'amplificateur au rythme de l'enveloppe du signal.

Selon un mode de réalisation particulier de l'invention, le commutateur est intégré dans le dernier étage de découplage de l'amplificateur, les composants constitutifs de l'ensemble des étages de découplage et de stockage de charges étant intégrés au plus près du transistor.

On va maintenant décrire un mode de mise en oeuvre du dispositif de l'invention, en référence au dessin annexé sur lequel :
- la figure 1 est un schéma de polarisation conventionnelle d'un étage final d'amplificateur RF ;
- la figure 2 représente le schéma de la figure 1 intégrant l'étage de commutation de tension selon l'invention, et
- la figure 3 est un schéma d'un amplificateur selon l'invention, intégrant l'étage de commutation de tension ainsi qu'une boucle feedforward.

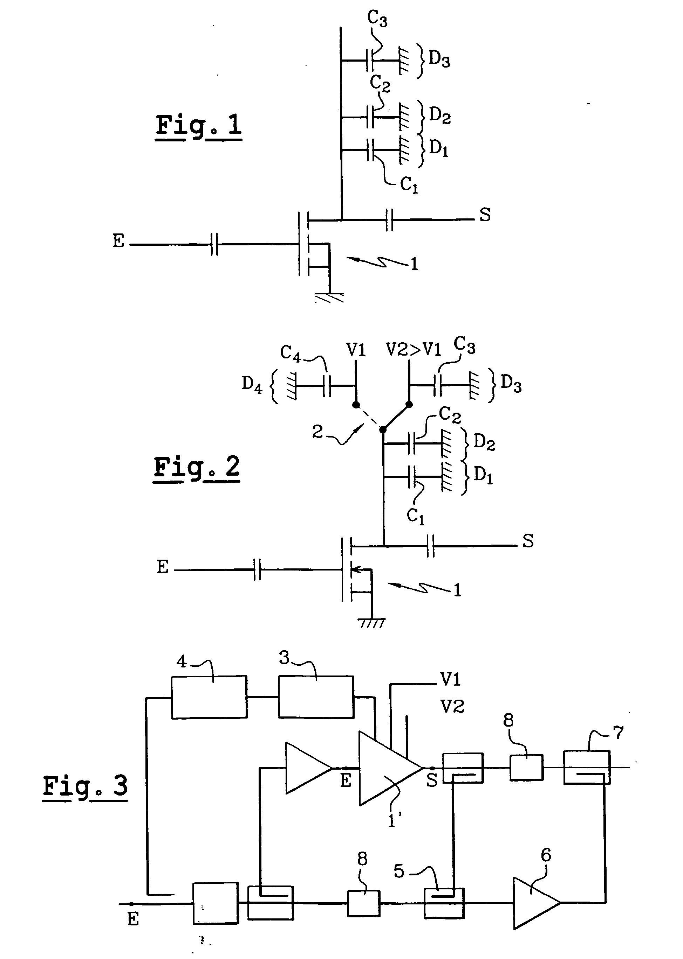

Sur la figure 1, on a représenté conventionnellement un transistor RF 1 d'amplification d'un signal d'entrée E présentant un rapport P crête/P moyen élevé. Le signal de sortie est disponible en S et la polarisation de drain du transistor par la tension Vdrain est assurée par une ligne quart d'onde constituant un premier étage D1 de découplage comprenant un condensateur RF à faibles pertes C1 de valeur suffisante pour présenter un court-circuit, un deuxième étage D2 de découplage comprenant un condensateur C2 de valeur plus élevée que celle de C1, capable de fournir du courant très rapidement au transistor 1 lors d'une brusque montée en puissance du signal E et un troisième étage D3 de découplage comprenant un condensateur C3 apte à fournir un courant fort pendant un temps plus long correspondant à un pic de puissance relativement long consécutif à la présence de composantes basses fréquences dans le signal d'entrée E.

A titre indicatif, pour un amplificateur à 2GHz, les condensateurs C1, C2, C3 peuvent avoir des valeurs respectives de 68 pF, 1 000 pF et quelques dizaines de µF.

Conformément à l'invention, la tension de drain du transistor 1 est assurée à partir de deux tensions d'alimentation distinctes respectivement V1 et V2, la tension V2 étant supérieure à la tension V1.

L'une ou l'autre de ces tensions est appliquée au drain via un commutateur symbolisé en 2, intégré au troisième étage D3.

Ce commutateur 2 permet d'appliquer au drain du transistor 1, juste en amont du deuxième étage de découplage D2, soit la plus forte (V2) des deux tensions, via le troisième étage de découplage D3, soit la plus faible (V1) via un quatrième étage de découplage D4 comprenant un condensateur C4 constituant un réservoir de charge à long terme assurant la stabilité de la tension drain pendant un laps de temps important.

Le commutateur 2 est commandé par un circuit de commande 3 relié à l'entrée E de l'amplificateur via un circuit de 4 détection d'enveloppe du signal.

Ainsi, lors de la détection de crêtes de puissance, c'est la tension V2 qui sera commutée sur le drain, le troisième étage de découplage D3 assurant au drain un courant fort le temps nécessaire qui peut être relativement long, alors que pendant les périodes hors crêtes le commutateur est commandé pour appliquer la tension inférieure V1 en substituant à l'étage D3 le quatrième étage D4, plus approprié à la situation et apte à assurer la stabilité de la tension drain sur une longue période qui peut atteindre 90 % du temps de fonctionnement de l'amplificateur.

On obtient ainsi un fonctionnement de l'amplificateur avec un rendement sensiblement plus intéressant tout en opérant une commutation propre en particulier par rapport à celle réalisée dans la demande de brevet US publiée N° 2002/0094795, grâce à l'intégration du commutateur dans le dernier étage de découplage (D3, D4) de l'amplificateur. Une telle intégration réduit substantiellement, notamment lorsque les commutations de tension sont très rapides, les inductances parasites qui induisent des détériorations (bruit, intermodulation) du signal de sortie S.

Les composants 2, C2, C3, C4 constitutifs de l'ensemble des étages de découplage et de stockage de charges selon l'invention sont choisis pour leur qualités de faible inductance et de faible résistance interne limitant les parasites générés et sont intégrés au plus près du transistor 1 afin d'assurer des commutations très rapides et néanmoins propres.

Il est à noter que le système de commutation de l'invention peut être généralisé à plus de deux tensions, à chaque tension étant associé un étage de découplage spécifique, en sorte de moduler la tension d'alimentation de l'amplificateur au rythme de l'enveloppe du signal E en sorte d'optimiser le rendement.

Par ailleurs, si l'amplificateur requiert une linéarité importante du signal de sortie S on peut avantageusement associer au dispositif de l'invention une correction de type feedforward qui va permettre de réduire encore plus les perturbations telles que le bruit ou l'intermodulation.

La figure 3 illustre une telle application de l'invention. En 1' est représenté l'étage amplificateur principal recevant en E le signal d'entrée et délivrant en S le signal de sortie. L'étage amplificateur 1' intègre les étages de découplage D1 à D4 et le commutateur 2 de la figure 2 et est connecté aux tensions d'alimentation V1 et V2.

Le commutateur 2 intégré à l'étage 1' est commandé par un circuit de commande 3 recevant également le signal d'entrée E via un circuit 4 de détection d'enveloppe.

Un échantillon du signal S est prélevé à la sortie de l'amplificateur principal 1' et comparé au signal d'entrée E dans un coupleur 5. Le résultat de cette comparaison, appelé signal d'erreur, est constitué de la distorsion subie par le signal et du bruit introduit par l'amplificateur principal 1'.

Ce signal d'erreur est alors amplifié par un amplificateur dit d'erreur 6, sa phase est tournée de 180°, puis il est réinjecté à l'aide d'un coupleur 7 sur le chemin principal du signal de sortie S de manière à produire une annulation de la distorsion. Tous les retards introduits par les divers amplificateurs sont compensés par des lignes à retard 8 de manière à rendre l'annulation indépendante de la fréquence.

Le principe de linéarisation du signal de sortie par une boucle de réaction amont du type feedforward est bien connu.

Cependant, l'inconvénient intrinsèque du feedforward, également bien connu, est la compression de gain de l'amplificateur lors des crêtes de puissance.

Mais cet inconvénient du feedforward est de manière tout à fait judicieuse supprimé grâce à l'association du feedforward à l'étage de commutation (2, D3, D4) intégré conformément à l'invention, dans l'amplificateur principal 1', lequel étage de commutation réduit les crêtes de puissance et met donc le feedforward dans des conditions évitant la manifestation desdits inconvénients du feedforward.

On améliore ainsi, tout à la fois la puissance crête (réduction du rapport P crête / P moyen), le rendement et la linéarité de l'amplificateur principal.

## Revendications

1. Amplificateur de puissance pour systèmes de transmission radiofréquences, dont le signal présente un rapport P crête/P moyen élevé, comprenant un étage d'amplification final (1, 1') à transistor à commutation de tension de drain sur au moins deux tensions d'alimentation (V1, V2) distinctes, la polarisation de drain étant constituée d'un premier étage de découplage (D1) comprenant une ligne quart d'onde suivie d'un deuxième étage (D2) de découplage apte à fournir un courant rapidement lors d'une brusque montée en puissance du signal et d'un troisième étage comprenant moins de découplage (D3) apte à fournir un courant fort lors de pics de puissance relativement longs, **caractérisé en ce que** ledit troisième étage intègre un étage de commutation de tension (2, D4), interposé entre lesdits moins de découplage (D3) et le deuxième étage et apte à commuter sur le drain l'une quelconque desdites tensions d'alimentation distinctes (V1, V2) en sorte que l'ensemble troisième étage de découplage (D3) et de commutation (2, D4) constitue des réservoirs de charge appropriés à toutes les tensions d'alimentation, permettant à la fois d'assurer la stabilité de la tension du drain pendant les périodes de temps hors crêtes du signal d'entrée et d'assurer un approvisionnement en courant suffisant dudit transistor pendant les crêtes.

2. Amplificateur suivant la revendication 1, **caractérisé en ce que** lesdites tensions d'alimentation distinctes comprennent deux tensions (V1, V2), ledit étage de commutation (2, D4) étant agencé en sorte de commuter sur le drain la tension d'alimentation la plus élevée (V2) en même temps que ledit troisième étage de découplage (D3) et la tension d'alimentation la moins élevée (V1) en même temps qu'un quatrième étage de découplage (D4) constituant un réservoir de charge à long terme assurant la stabilité de la tension drain.

3. Amplificateur suivant la revendication 1 ou 2, **caractérisé en ce que** ledit amplificateur (1') comporte une boucle de réaction amont (5 à 8) dénommée feedforward en sorte de corriger les perturbations transitoires et réduire l'impact des compressions de gain de l'amplificateur.

4. Amplificateur selon l'une quelconque des revendications précédentes **caractérisé en ce que** l'étage de commutation de tension (2) est commandé par un circuit de commande (3) relié à l'entrée (E) de l'amplificateur via un circuit de (4) détection d'enveloppe du signal.

5. Amplificateur selon la revendication 4 **caractérisé en ce que** le commutateur 2 commute plus de deux tensions, à chaque tension étant associé un étage de découplage spécifique, en sorte de moduler la tension d'alimentation de l'amplificateur au rythme de l'enveloppe du signal E.

6. Amplificateur selon l'une des revendications précédentes **caractérisé en ce que** le commutateur est intégré dans le dernier étage de découplage (D3, D4) de l'amplificateur principal 1', les composants (2, C2, C3, C4) constitutifs de l'ensemble des étages de découplage et de stockage de charges étant intégrés au plus près du transistor 1.

## Claims

1. A power amplifier for radio frequency transmission systems, whose signal has a high peak power to mean power ratio, comprising a final amplification stage (1, 1') with a drain voltage switching transistor on at least two distinct supply voltages (V1, V2), the drain biasing being formed of a first decoupling stage (D1) comprising a quarter-wave line followed by a second decoupling stage (D2) able to supply a current quickly during an abrupt rise in power of the signal and a third stage (D3) comprising decoupling means able to supply a strong current during relatively long power peaks, **characterised in that** said third stage includes a voltage switching stage (2, D4) interposed between said decoupling means (D3) and the second stage and able to switch onto the drain any one of said distinct supply voltages (V1, V2) so that the assembly of third decoupling stage (D3) and switching stage (2, D4) constitutes charge reservoirs appropriate to all the supply voltages, making it possible both to ensure stability of the voltage of the drain during off-peak time periods of the input signal and to ensure sufficient supply of current to said transistor during the peaks.

2. An amplifier according to claim 1, **characterised in that** said distinct supply voltages comprise two voltages (V1, V2), said switching stage (2, D4) being arranged so as to switch onto the drain the highest supply voltage (V2) at the same time as said third decoupling stage (D3) and the less high supply voltage (V1) at the same time as a fourth decoupling stage (D4) constituting a long-term charge reservoir ensuring stability of the drain voltage.

3. An amplifier according to claim 1 or 2, **characterised in that** said amplifier (1') comprises an upstream feed loop (5 to 8) denominated feedforward so as to correct the transient interference and to reduce an impact of the amplifier gain compressions.

4. An amplifier according to any one of the preceding claims, **characterised in that** the voltage switching stage (2) is controlled by a control circuit (3) connected to the input (E) of the amplifier via a signal envelope detection circuit (4).

5. An amplifier according to claim 4, **characterised in that** the switch (2) switches more than two voltages, a specific decoupling stage being associated with each voltage, so as to modulate the amplifier supply voltage at the rhythm of the envelope of the signal E.

6. An amplifier according to one of the preceding claims, **characterised in that** the switch is integrated in the last decoupling stage (D3, D4) of the principal amplifier (1'), the components (2, C2, C3, C4) forming the assembly of the charge storage and decoupling stages being integrated as close as possible to the transistor (1).

## Patentansprüche

1. Leistungsverstärker für ein Radiofrequenzübertragungssystem, dessen Signal ein hohes Verhältnis von P maximal/P mittel aufweist, welcher eine finale Verstärkungsstufe (1, 1') mit Drain-Spannungs-Schaltungstransistor bezüglich mindestens zweier verschiedener Speisespannungen (V1, V2) umfasst, wobei die Polarisation des Drains aus einer ersten Entkopplungsstufe (D1) besteht, welche eine Viertelwellen-Leitung umfasst, gefolgt von einer zweiten Entkopplungsstufe (D2), welche fähig ist, im Falle eines plötzlichen Anstiegs der Signalleistung schnell einen Strom zu liefern, und einer dritten Stufe, welche Mittel zur Entkopplung (D3) umfasst, welche dazu geeignet sind, im Falle relativ langer Leistungsspitzen einen starken Strom zu liefern, **gekennzeichnet dadurch, dass** die besagte dritte Stufe eine Stufe der Spannungsschaltung (2, D4) integriert, welche zwischen den besagten Mitteln zur Entkopplung (D3) und der zweiten Stufe positioniert ist, und welche fähig ist, auf dem Drain eine beliebige der besagten bestimmten Speisespannungen (V1, V2) zu schalten, derart, dass die Gesamtheit der dritten Stufe der Entkopplung (D3) und der Schaltung (2, D4) Reservoirs von Ladung darstellt, welche für alle Speisespannungen geeignet sind, und es so ermöglichen, dass sowohl die Stabilität der Drain-Spannung während Zeitperioden zu gewährleisten, in denen das Eingangssignal nicht maximal ist, und eine Versorgung mit ausreichendem Strom des besagten Transistors während der Maxima zu gewährleisten.

2. Der Verstärker gemäß Anspruch 1, **gekennzeichnet dadurch, dass** die besagten verschiedenen Speisespannungen zwei Spannungen (V1, V2) umfassen, wobei die besagte Schaltungsstufe (2, D4) derart betrieben werden kann, dass sie auf dem Drain die höchste Speisespannung (V2) zur gleichen Zeit wie die besagte dritte Stufe der Entkopplung (D3), und die niedrigste Speisespannung (V1) zur gleichen Zeit wie eine vierte Stufe der Entkopplung (D4) schaltet, welche ein Langzeitladungsreservoir darstellt, welches die Stabilität der Drainspannung sicherstellt.

3. Der Verstärker gemäß Anspruch 1 oder 2, **gekennzeichnet dadurch, dass** der besagte Verstärker (1') eine vorgelagerte Reaktionsschleife (5 bis 8) umfasst, welche Feedforward genannt wird, derart dass vorübergehende Störungen korrigiert werden und die Wirkung der Verstärkungskompressionen des Verstärkers reduziert werden.

4. Verstärker gemäß einem beliebigen vorangegangenen Anspruch, **gekennzeichnet dadurch, dass** die Spannungsschaltungs-Stufe (2) durch einen Steuerungsschaltkreis (3) gesteuert wird, welcher mit dem Eingang (E) des Verstärkers über einen Schaltkreis (4) zur Bestimmung der Einhüllenden des Signals verbunden ist.

5. Verstärker gemäß Anspruch 4, **gekennzeichnet dadurch, dass** der Schalter 2 mehr als zwei Spannungen schaltet, wobei mit jeder Spannung eine spezifische Entkopplungsstufe assoziiert ist, derart, dass die Speisespannung des Verstärkers im Rhythmus der Einhüllenden des Signals E moduliert wird.

6. Verstärker gemäß einem beliebigen vorangegangenen Anspruch, **gekennzeichnet dadurch, dass** der Schalter in der letzten Entkopplungsstufe (D3, D4) des Hauptverstärkers 1' integriert ist, wobei die Komponenten (2, C2, C3, C4), welche die Gesamtheit der Stufen der Entkopplung und der Ladungsspeicherung konstituieren, so nah wie möglich am Transistor 1 integriert sind.
